(19) **Europäisches Patentamt**
**European Patent Office**
**Office européen des brevets**

(11) **EP 1 840 955 B1**

(12) **EUROPEAN PATENT SPECIFICATION**

(45) Date of publication and mention
of the grant of the patent:
**09.01.2008 Bulletin 2008/02**

(51) Int Cl.:
**H01L 21/762** $^{(2006.01)}$

(21) Application number: **06290542.7**

(22) Date of filing: **31.03.2006**

(54) **Method for fabricating a compound material and method for choosing a wafer**

Verfahren zur Herstellung eines Verbundmaterials und Verfahren zur Auswahl eines Wafers

Méthode de fabrication d'un matériau composite et méthode de sélection d'une plaquette

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**03.10.2007 Bulletin 2007/40**

(73) Proprietor: **S.O.I.TEC. Silicon on Insulator Technologies S.A.**
**Bernin 38926 Crolles Cédex (FR)**

(72) Inventors:
• **Ecarnot, Ludovic**
**38450 Vif (FR)**
• **Willy, Michael**
**38100 Grenoble (FR)**
• **Reynaud, Patrick**
**38400 Saint Matin D'Hères (FR)**
• **Schwarzenbach, Walter**
**38330 Saint Nazaire Les Eymes (FR)**

(74) Representative: **Grünecker, Kinkeldey, Stockmair & Schwanhäusser**
**Anwaltssozietät**
**Maximilianstrasse 58**
**80538 München (DE)**

(56) References cited:
**EP-A- 1 566 830        WO-A-20/04008527**
**US-A1- 2002 187 595**

• **MALEVILLE C., CELLER G.: "SOI: challenges and solutions to increasing yield in an ultrathin age" YIELD MANAGEMENT SOLUTIONS -(KLA-TENCOR MAGAZINE, vol. 6, no. 2, 2004, pages 1-84, XP002389358**
• **KIMURA M ET AL: "A NEW METHOD FOR THE PRECISE MEASUREMENT OF WAFER ROLL OFF OF SILICON POLISHED WAFER" JAPANESE JOURNAL OF APPLIED PHYSICS, JAPAN SOCIETY OF APPLIED PHYSICS, TOKYO, JP, vol. 38, no. 1A, PART 1, January 1999 (1999-01), pages 38-39, XP000891091 ISSN: 0021-4922**

EP 1 840 955 B1

**Description**

The invention relates to a method for fabricating a compound material wafer, and in particular a silicon insulator (SOI) type wafer, comprising the steps of: providing two wafers and attaching, in particular by bonding, the one wafer to the other. The invention, furthermore, relates to a method for choosing a wafer which is suitable for the fabrication process of a compound material wafer and to the use of a wafer in the fabrication process of a compound material wafer.

On the final product, e.g. a SOI wafer, defects, in particular voids, can be observed in the vicinity of the outer periphery of the compound material wafer. From EP 1566830 it is known that the amount of defects of this type can reduced by carrying out the SOI fabrication process with wafers for which the configuration change is 0.1 nm or less, in a region between 10 mm and 3 mm away from the outer periphery. Alternatively, wafers with a slope of 0.02 % or less at a position of 5 mm away from the outer periphery lead to SOI wafers with reduced defects.

It is the object of the present invention to provide an alternative method for fabricating a compound material wafer and/or an alternative method for choosing a wafer which is suitable for the fabrication process of a compound material wafer, so that the generation of defects in the outer periphery of the compound material wafers can be reduced.

This object is achieved with the method for fabricating a compound material wafer according to claim 1. This object is also achieved with the method for choosing a wafer according to claims 2.

Surprisingly, by determining the edge role off value using the second derivative of the profile of each of the wafers and by using only wafers with an edge role off value (ERO) of more than 50 nm, and in particular more than 100 nm, more in particular of more than 150 nm, in the fabrication process of the wafers, the number of voids generated close to the periphery of the wafer can be reduced.

Here the term "profile" stays for a height profile of the wafer in the radial direction for the surface at which attachment to the other wafer will occur. Furthermore the two wafers need not to be of the same material and can be provided or not with further layers.

According to a preferred embodiment, the second derivative used to determine the edge roll of value which can be obtained by determining: $ERO = Y(a) - Y(fqa)$, wherein a and fqa correspond to two positions on a radius of the wafer and wherein $Y(a)$ corresponds to the height of the wafer at a radial position for which the second derivative $Y''(a)$ is zero, and $Y(fqa)$ corresponds to the height of the wafer at a radial position of about 0.5 mm to 2.5mm, in particular at about 1mm, away from the outer periphery. Using this method and with edge roll off values of more than 50 nm, and in particular of more than 100 nm, even more in particular of more than 150 nm, for both wafers even further improved results concerning the defects have been achieved.

Preferably, each of the wafers can be a 300 mm type wafer. For 300 mm type wafers, more voids are generated than for smaller wafers, so that ways to reduce the number of voids for this class of wafers is of particular interest for the large size wafers. For even larger wafers, e.g. 450 mm wafers, this is also expected to be the case.

Advantageously the ERO can be determined at several positions of the wafer and an average ERO is calculated from the individual ERO values. Thus inhomogeneous wafer edges can be taken into account.

Preferably the method can further comprise a step of providing an insulating layer on at least one of the two wafers prior to attaching the wafers. Reduced numbers of voids for the ERO values determined on the basis of the second derivative method are observed for compound material wafer structures comprising an insulating layer, like for example SOI type wafers.

Advantageously the method can further comprise a step of forming a predetermined splitting area in one of the wafers. Such a method step is used to enable the transfer of a thin layer of material from one wafer onto the other and voids are created in the thin layer- Even when using this method, reduced numbers of voids for the ERO values determined on the basis of the second derivative method are observed for compound material wafer structures fabricated this way.

According to a preferred embodiment the edge roll off value determination and/or the choosing of a wafer can be carried out after the step of providing an insulating layer on at least one of the two wafers or after the additional step of forming a predetermined splitting area in one of the wafers. Here the ERO value is determined just before the bonding on the wafers like they are going to be bonded.

The invention also relates to the use of a wafer according to one of claim7.

Specific embodiments of the present invention will become more apparent from the following description with reference to the accompanying drawings wherein:

Figs. 1a to 1e illustrate the fabrication process of compound material wafers like known in the art,

Figs. 2a and 2b illustrates a compound material wafer known in the art with defects close to the outer periphery in a top view and in a crosscut view,

Fig. 3 is a block diagram illustrating an embodiment of the inventive method for fabricating a compound material wafer,

Fig. 4 illustrates the way of determining the edge roll off value using the second derivative, and

Fig. 5 is a three-dimensional diagram representing the average number of void defects as a function of the ERO value of the two wafers used in the fabricating process of a compound material wafer.

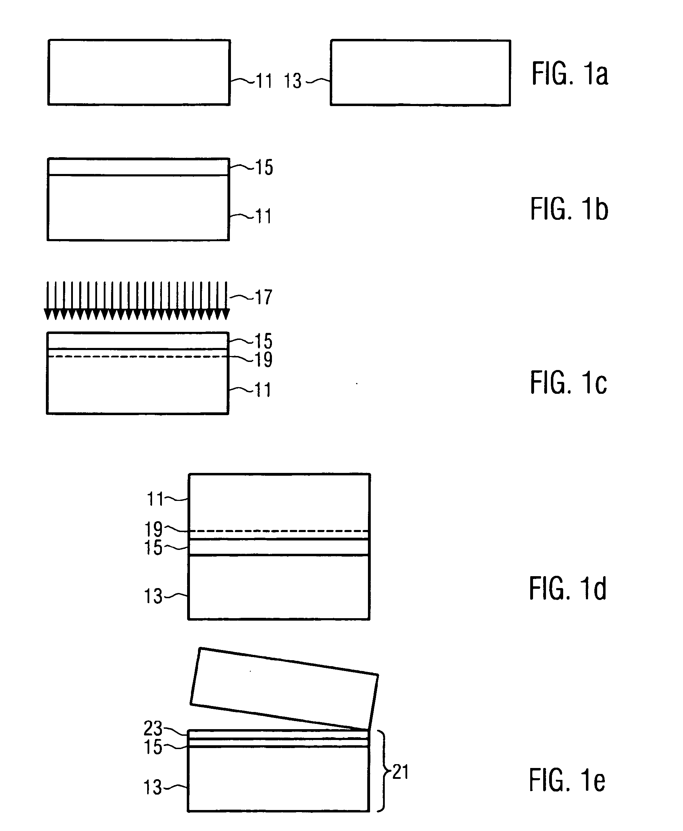

A state of the art compound material fabrication process, applicable in particular to SOI wafers, is illustrated in Fig. 1. It comprises the following steps and will be described for a SOI wafer:

In the first step, illustrated in Fig. 1 a, two Si wafers 11 and 13, e.g. 300 mm wafers, are provided. In the second step, shown in Fig. 1b, a thermal oxide layer 15 is grown on wafer 11. During a thermal growth actually the wafer gets encapsulated by the oxide. The oxide on the back and on the side is, however, removed at a later stage. In the following step, illustrated in Fig. 1c, atomic species 17, like hydrogen ions or rare gas ions, are implanted through the thermal oxide layer 15 into wafer 11, to thereby create a predetermined splitting area 19 inside wafer 11. Then in the following step, the second wafer 13 is bonded to wafer 11, such that the oxide layer 15 is positioned between wafer 13 and 11.

Then, energy, in particular thermal energy, is provided to the bonded wafer system such that detachment occurs at the predetermined splitting area 19 to thereby create the desired silicon on insulator wafer 21 comprising the initial wafer 13, the oxide layer 15 and a transferred layer 23 which had its origin from wafer 11.

Of course, instead of creating a silicon on insulator wafer 21, also other types of compound material wafers can be fabricated using this process. An example for another compound material wafer would be: strained Silicon on insulator (sSOI), SiGeOI, GeOI, silicon on quartz SOQ or direct silicon bonding wafers (DSB). In addition, further layers may be present.

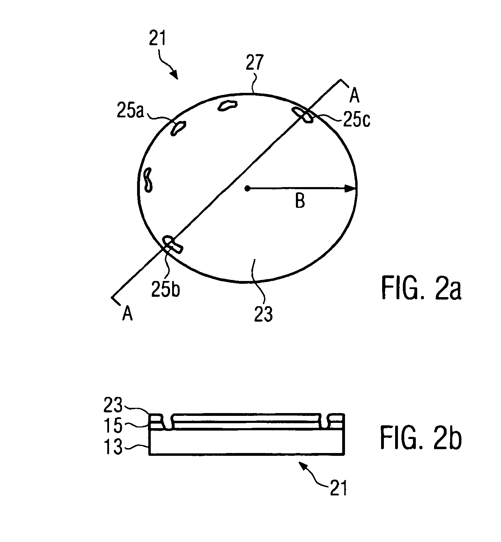

Fig. 2a illustrates a top view of the silicon on insulator wafer 21 obtained by the described method. On the surface of the transferred layer 23 defects 25a, 25b and 25c etc. can be observed. They are positioned at about 3 mm away from the edge 27 of the SOI wafer 21. The size of the defects in the figure is exaggerated

for illustrative purposes. In reality they have a size of approximately 1 mm in diameter.

Fib. 2b illustrates a cross cut along line AA shown in Fig. 2a. It can be seen that the defects 25b and 25c correspond to areas where the transfer of layer 23 was not complete. These voids can go the whole way through the transferred layer and the insulating layer 15 to reach the interface at which bonding occurred. These defects are usually attributed to bonding defects. When two wafers are bonded, they are actually put into close contact to each other and then a pressure is applied, typically on one edge of the wafer. On the edge opposite to the point where bonding has been initiated perturbations of the bonding wafer can occur which then can lead to the observed defects, e.g. due to a locally lower bonding force.

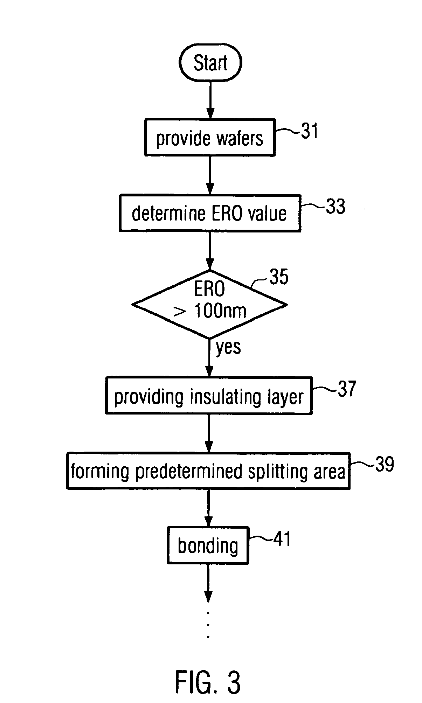

Fig. 3 is a block diagram illustrating an embodiment of the inventive method for manufacturing compound material wafers which allows a reduction of the described type of defects, at least on average over a certain number of wafers, for example, over about 10 000 wafers.

The first step 31 consists in providing two wafers, like in the method illustrated in Fig. 2a. Next in step 33, the edge roll off value of each of the wafers is determined. With the bonding defects 25a, 25b and 25c as shown in Fig. 2a and 2b predominantly being present up to about 3 mm from the edge 27 of the compound material wafer 21, the edge roll off value according to the first embodiment of the invention is determined preferably at about 0.5 mm - 2.5 mm, in particular, at 1 mm away from the outer periphery 27 of the wafers 11 and 13.

According to the invention the edge roll off value is determined using the second derivative of the profile of the wafers Y(r). The profile Y(r) corresponds to the height profile in the radial direction r, usually expressed in nm, of the surface at which later on attachment will occur. Alternatively also the wafer thickness profile may be used. The edge roll off value is determined using the second derivative of the profile of the wafer, and is defined by:

$$ERO = Y(a) - Y(fqa) \qquad (1)$$

Thus ERO, expressed in nm, is the difference of height (or thickness) between two locations, namely the location at radius "a" and at radius "fqa". The value of "fqa" is chosen to be in a the range of a radius of 147.5 mm to 149.5 mm, in particular, at a radius of 149 mm, in case of a 300 mm wafer.

The value of "a" is not a fixed value of a radius of the wafer, but corresponds to the first position starting from "fqa" in the direction towards the center, for which the second derivative of Y(r) is equal to zero: Y"(a)=0.

The second derivative is preferably determined using a numerical process based on the profile measurement of the wafers. It is determined at several positions of the wafer and from the individual values, an average ERO value can be calculated, e.g. from the measured profile itself or by reintegrating twice the second derivative profile. Double integration is typically used to filter out erroneous contributions to the ERO value, which can be due to a misalignment of the wafer on the measurement chuck, leading e.g. to a slightly skipped wafer.

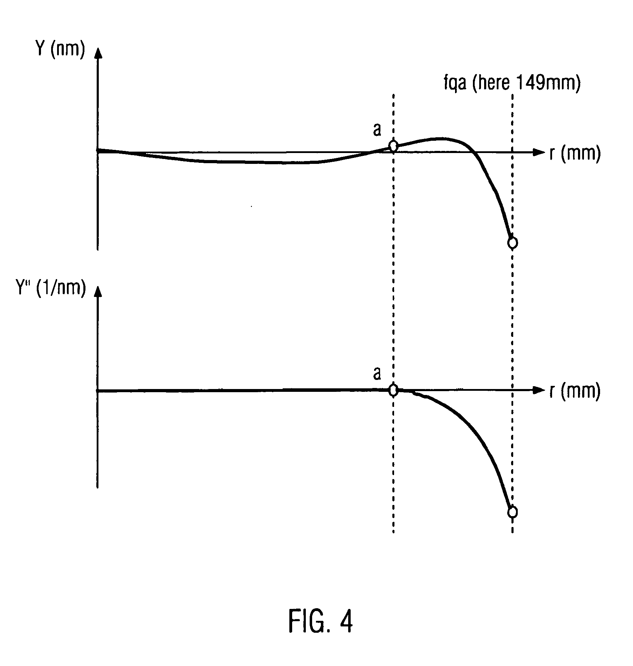

Fig. 4 illustrates this process. The top view illustrates the height profile of a wafer which is determined in the radial direction at one or more positions on the wafer, for example along line B shown in Fig. 2a. The second derivative is illustrated in the bottom view. It is numerically calculated using the height profile. Using this data the position "a" for which the second derivative is zero is determined. Then the corresponding wafer heights Y(a) and Y(fqa) are determined from which in turn the ERO value is calculated using equation (1).

Then in the step 35, only such wafers are chosen for further processing which have an ERO value of more than 50 nm, in particular more than 100 nm.

The inventive process then continues with the steps of providing an insulating layer, like layer 15 shown in figure 1b, on at least one of the two wafers (step 37). A predetermined splitting area is then provided (step 39), which corresponds to the process step shown in figure 1c. Then in step 41, the wafers are attached to each other, which corresponds to the process step illustrated in Fig. 1d. The detailed description of the method steps illustrated in Fig. 1 is incorporated herewith by reference.

According to variants of embodiments 1 and 2, the edge roll off value determination step 33 and the choosing step 35 could also be carried out after providing an insulating layer 15 on at least one of the two wafers 11, 13 or even after the step of forming a predetermined splitting area 17 in one of the wafers 11, 13.

Furthermore, according to the a second embodiment of the invention steps 33 and 35 could also be carried out as an independent method for choosing a wafer which is suitable for the fabrication process of a compound material wafer as illustrated in Fig. 2.

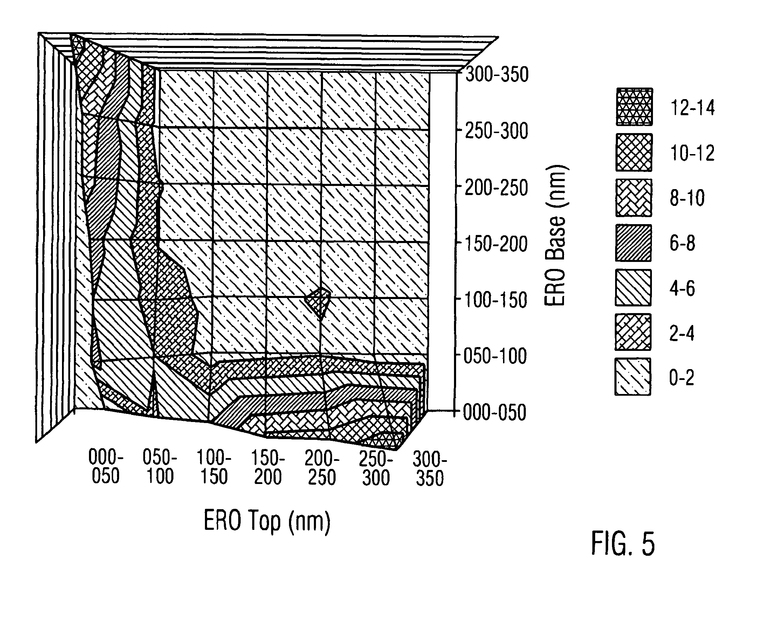

Fig. 5 illustrates the advantageous effect of only using wafers which have an edge roll off value of more than 50 nm, in particular, more than 100 nm, even more in particular more than 150 nm. Fig. 5 is a three-dimensional diagram wherein the average number of crystalline defects for a sample of 10 000 wafers is plotted against the determined edge roll off values of

$$ERO = Y(a) - Y(fqa = 149mm)$$

for both the wafer 11 serving as a donor substrate and the second wafer 13 serving as a support substrate in the fabrication of a SOI wafer 21. The wafers were analysed using a Raytex DynaSearch tool, which establishes the ERO value based on the second derivative.

As can be clearly seen, the amount of defects of the type as shown in Fig. 2a and Fig. 2b can reach in average more than ten in case the edge roll off value for both wafers is less than 50 nm and more than two in case the edge roll off value is less than 100 nm, wherein the edge roll off value has been determined using the double derivative method. At the opposite, the amount of these defects is in average less than two in case the edge roll off value of both wafers is more than 100 nm.

## Claims

1. Method for fabricating a compound material wafer, in particular a silicon-on insulator (SOI) type wafer, comprising the steps of:

    providing two wafers (11, 13);
    attaching, in particular bonding, the one wafer to the other,
    **characterized in**
    determining prior to attaching an edge roll off (ERO) value of each of the two wafers using the second derivative of the profile of each of the wafers (11, 13) and using wafers with an ERO of more than 50nm, in particular, more than 100nm, more in particular, more than 150nm,
    wherein the ERO is obtained by determining:

$$ERO = Y(a) - Y(fqa),$$

wherein a and fqa correspond to two positions on a radius of the wafer and wherein Y(a) corresponds to the height of the wafer at the first radial position starting from "fqa" in the direction towards the center for which the second derivative Y" is zero, and Y(fqa) corresponds to the height of the wafer at a radial position of about 0.5mm to 2.5 mm, in particular at about 1 mm, away from the outer periphery (27).

2. Method for choosing a wafer in the fabrication process of a compound material wafer according to the preamble of claim 1,
**characterized in that**
the second derivative of the profile of a wafer is determined to establish the edge roll off (ERO) value of the wafer and only wafers with an ERO of more than 50nm, in particular more than 100nm, more in particular, more than 150nm, are chosen for the fabrication process,
wherein the ERO is obtained by determining:

$$ERO = Y(a) - Y(fqa),$$

wherein a and fqa correspond to two positions on a radius of the wafer and wherein Y(a) corresponds to the height of the wafer at the first radial position starting from "fqa" in the direction towards the center for which the second derivative Y" is zero, and Y(fqa) corresponds to the height of the wafer at a radial position of about 0.5mm to 2.5 mm, in particular at about 1 mm, away from the outer periphery (27).

3. Method according to one of claims 1 or 2, wherein each of the wafers (11, 13) is a 300mm type wafer.

4. Method according to one of claims 1 to 3, wherein the ERO is determined at several positions of the wafer and wherein an average ERO is calculated from the individual values.

5. Method according to one of claims 1 to 4, further comprising a step of providing an insulating layer (15) on at least one of the two wafers (11, 13) prior to attaching the wafers.

6. Method according to one of claims 1 to 5, further comprising a step of forming a predetermining splitting area (17) in one of the wafers (11, 13).

7. Use of a wafer with an edge roll off (ERO) value of more than 50nm, in particular more than 100nm, more in particular, more than 150nm, in the fabrication process of a compound material wafer (21), in particular a silicon-on-insulator type wafer,
wherein the ERO is obtained by determining:

$$ERO = Y(a) - Y(fqa),$$

wherein a and fqa correspond to two positions on a radius of the wafer and wherein Y(a) corresponds to the height of the wafer at the first radial position starting from "fqa" in the direction towards the center for which the second derivative Y"(a) is zero, and Y(fqa) correspond to the height of the wafer at a radial position of about 0.5mm to 2.5mm, in particular at about 1 mm away from the outer periphery (27).

**Patentansprüche**

1. Verfahren zum Herstellen eines Verbundwerkstoffwafers, in besondere eines Wafers des Typs Silicon on Insulator (SOI), mit den Schritten:

Bereitstellen von zwei Wafern (11, 13),
Befestigen, insbesondere durch Bonden, des einen Wafers auf den Anderen,
**dadurch gekennzeichnet, dass**
vor dem Befestigen ein Edge Roll Off (ERO) Wert für beide Wafer bestimmt wird,

wobei jeweils die zweite Ableitung des Profils der Wafer (11, 13) bestimmt wird und Wafer benutzt werden, die einen ERO von mehr als 50 nm, insbesondere von mehr als 100 nm, insbesondere von mehr als 150 nm, haben, wobei der ERO durch:

$$ERO = Y(a) - Y(fqa),$$

bestimmt wird, wobei a und fqa zwei Positionen auf einem Radius des Wafers sind, Y(a) der Höhe des Wafers an der ersten radialen Position entspricht an der, ausgehend von "fqa" in Richtung des Mittelpunkts, die zweite Ableitung Y" gleich Null ist und Y(fqa) der Höhe des Wafers an einer Position entspricht, die ungefähr 0,5 mm bis 2,5 mm, insbesondere ungefähr 1mm, vom Rand (27) entfernt ist.

2. Verfahren zum Auswählen eines Wafers für das Herstellungsverfahren eines Verbundwerkstoffwafers gemäß dem Oberbegriff des Anspruchs 1,
**dadurch gekennzeichnet, dass**
die zweite Ableitung des Profils eines Wafers (11, 13) bestimmt wird, um den Edge Roll Off (ERO) Wert des Wafers zu bestimmen und nur Wafer für das Herstellungsverfahren benutzt werden, die einen ERO von mehr als 50 nm, insbesondere von mehr als 100 nm, insbesondere von mehr als 150 nm, haben,
wobei der ERO durch:

$$ERO = Y(a) - Y(fqa),$$

bestimmt wird, wobei a und fqa zwei Positionen auf einem Radius des Wafers sind, Y(a) der Höhe des Wafers an der ersten radialen Position entspricht an der, ausgehend von "fqa" in Richtung des Mittelpunkts, die zweite Ableitung Y" gleich Null ist und Y(fqa) der Höhe des Wafers an einer Position entspricht, die ungefähr 0,5 mm bis 2,5 mm, insbesondere ungefähr 1mm, vom Rand (27) entfernt ist.

3. Verfahren nach Anspruch 1 oder 2, wobei jeder der Wafer (11, 13) ein Wafer des Typs 300 mm ist.

4. Verfahren nach einem der Ansprüche 1 bis 3, wobei der ERO an mehreren Stellen des Wafers bestimmt wird und ein ERO Mittelwert aus den einzelnen Werten berechnet wird.

5. Verfahren nach einem der Ansprüche 1 bis 4 mit einem weiteren Schritt:

   Bereitstellen, vor dem Befestigen der Wafer, einer nicht leitenden Schicht (15) auf mindestens einem der beiden Wafer (11, 13).

6. Verfahren nach einem der Ansprüche 1 bis 5 mit einem weiteren Schritt:

   Bilden einer vorbestimmten Splittingzone (17) in einem der Wafer (11, 13).

7. Verwendung eines Wafers mit einem Edge Roll Off (ERO) Wert von mehr als 50 nm, insbesondere von mehr als 100 nm, insbesondere von mehr als 150 nm, im Herstellungsverfahren eines Verbundwerkstoffwafers (21), insbesondere eines Wafers des Typs Silicon on Insulator, wobei der ERO durch:

$$ERO = Y(a) - Y(fqa),$$

bestimmt wird, wobei a und fqa zwei Positionen auf einem Radius des Wafers sind, Y(a) der Höhe des Wafers an der ersten radialen Position entspricht an der, ausgehend von "fqa" in Richtung des Mittelpunkts, die zweite Ableitung Y" gleich Null ist und Y(fqa) der Höhe des Wafers an einer Position entspricht, die ungefähr 0,5 mm bis 2,5 mm, insbesondere ungefähr 1mm, vom Rand (27) entfernt ist.

**Revendications**

1. Procédé de fabrication d'une tranche en matériau composite, en particulier d'une tranche du type silicium sur isolant (SOI - Silicon-On-Insulator), comprenant les étapes consistant à :

   fournir deux tranches (11, 13) ;
   lier, en particulier par collage, l'une des
   tranches à l'autre,

   **caractérisé par**
   la détermination, préalablement à la liaison, d'une valeur de pente de bordure (ERO - Edge Roll Off) de chacune des deux tranches en utilisant la dérivée seconde du profil de chacune des tranches (11, 13) et en utilisant des tranches ayant une ERO supérieure à 50 nm, en particulier, supérieure à 100 nm, tout particulièrement, supérieure à 150 nm,
   dans lequel l'ERO est obtenue en déterminant :

$$ERO = Y(a) - Y(fqa),$$

   dans lequel a et fqa correspondent à deux positions sur un rayon de la tranche et dans lequel Y(a) correspond à la hauteur de la tranche au niveau de la première position radiale en partant de « fqa » dans la direction du centre pour laquelle la dérivée seconde Y" est égale à zéro, et Y (fqa) correspond à la hauteur de la tranche au niveau d'une position radiale d'environ 0,5 mm à 2,5 mm, en particulier à environ 1 mm, en partant du bord extérieur (27).

2. Procédé de sélection d'une tranche pour le procédé de fabrication d'une tranche en matériau composite selon le préambule de la revendication 1,
   **caractérisé en ce que**
   la seconde dérivée du profil d'une tranche est déterminée pour établir la valeur de pente de bordure (ERO) de la tranche et seules des tranches ayant une ERO supérieure à 50 nm, en particulier, supérieure à 100 nm, tout particulièrement, supérieure à 150 nm, sont choisies pour le procédé de fabrication,
   dans lequel l'ERO est obtenue en déterminant :

$$ERO = Y(a) - Y(fqa),$$

   dans lequel a et fqa correspondent à deux positions sur un rayon de la tranche et dans lequel Y(a) correspond à la hauteur de la tranche au niveau de la première position radiale en partant de « fqa » dans la direction du centre pour laquelle la dérivée seconde Y" est égale à zéro, et Y(fqa) correspond à la hauteur de la tranche au niveau d'une position radiale d'environ 0,5 mm à 2,5 mm, en particulier à environ 1 mm, en partant du bord extérieur (27).

3. Procédé selon la revendication 1 ou la revendication 2, dans lequel chacune des tranches (11, 13) est une tranche du type 300 mm.

4. Procédé selon l'une quelconque des revendications 1 à 3, dans lequel l'ERO est déterminée en plusieurs positions de la tranche et dans lequel une ERO moyenne est calculée à partir des valeurs individuelles.

5. Procédé selon l'une quelconque des revendications 1 à 4, comprenant en outre une étape consistant à fournir une couche isolante (15) sur au moins l'une des deux tranches (11, 13) préalablement à la liaison des tranches.

6. Procédé selon l'une quelconque des revendications 1 à 5, comprenant en outre une étape consistant à former une zone de clivage prédéfinie (17) dans l'une des tranches (11, 13).

7. Utilisation d'une tranche ayant une valeur de pente de bordure (ERO) supérieure à 50 nm, en particulier supérieure à 100 nm, tout particulièrement, supérieure à 150 nm, dans le procédé de fabrication d'une tranche de matériau composite (21), en particulier d'une tranche du type silicium sur isolant,
   dans lequel l'ERO est obtenue en déterminant :

$$ERO = Y(a) - Y(fqa),$$

dans lequel a et fqa correspondent à deux positions sur un rayon de la tranche et dans lequel Y(a) correspond à la hauteur de la tranche au niveau de la première position radiale en partant de « fqa » dans la direction du centre pour laquelle la dérivée seconde Y" est égale à zéro, et Y(fqa) correspond à la hauteur de la tranche au niveau d'une position radiale d'environ 0,5 mm à 2,5 mm, en particulier à environ 1 mm, en partant du bord extérieur (27).

FIG. 1a

FIG. 1b

FIG. 1c

FIG. 1d

FIG. 1e

21

27

25a

25c

A

B

25b

A

FIG. 2a

23

23
15
13

FIG. 2b

21

Start

provide wafers 31

determine ERO value 33

ERO > 100nm 35

yes

providing insulating layer 37

forming predetermined splitting area 39

bonding 41

⋮

FIG. 3

FIG. 4

FIG. 5

**EP 1 840 955 B1**

**REFERENCES CITED IN THE DESCRIPTION**

**Patent documents cited in the description**

- EP 1566830 A